# EUROPÄISCHE PATENTSCHRIFT

(11) **EP 0 784 517 B1**
(45) Veröffentlichungstag und Bekanntmachung des Hinweises auf die Patenterteilung: **14.04.1999**
(21) Anmeldenummer: 95934649.5
(22) Anmeldetag: 28.09.1995
(51) Int. Cl.: B08B 3/00, B08B 3/02, H01L 21/306, H01L 21/00, B08B 11/02

(54) **VERFAHREN UND VORRICHTUNG ZUM FEINSTREINIGEN VON OBERFLÄCHEN**
PROCESS AND DEVICE FOR THOROUGHLY CLEANING SURFACES
PROCEDE ET DISPOSITIF DE NETTOYAGE APPROFONDI DE SURFACES

(30) Priorität: 04.10.1994 DE 4435414; 30.11.1994 DE 4442582; 24.02.1995 DE 19506594; 23.06.1995 DE 19522525
(43) Veröffentlichungstag der Anmeldung: 23.07.1997
(73) Patentinhaber: Kunze-Concewitz, Horst, 75446 Wiernsheim (DE)
(72) Erfinder: Kunze-Concewitz, Horst, 75446 Wiernsheim (DE)
(74) Vertreter: Steimle, Josef, Dipl.-Ing.
(86) Internationale Anmeldenummer: EP9503838
(87) Internationale Veröffentlichungsnummer: WO9610463

(56) Entgegenhaltungen:
- EP-A- 0 381 435
- EP-A- 0 455 465
- EP-A- 0 548 504
- IBM TECHNICAL DISCLOSURE BULLETIN, Bd. 20, Nr. 3, August 1977 Seite 950 G.A. DEIGHTON 'steam and water spray wafer cleaning'
- PATENT ABSTRACTS OF JAPAN vol. 9 no. 85 (E-308) ,13.April 1985 & JP,A,59 215729 (NIPPON SHINKU GIJUTSU KK) 5.Dezember 1984,
- PATENT ABSTRACTS OF JAPAN vol. 17 no. 150 (E-1339) ,25.März 1993 & JP,A,04 315429 (HITACHI LTD) 6.November 1992,
- PATENT ABSTRACTS OF JAPAN vol. 11 no. 245 (E-531) ,11.August 1987 & JP,A,62 060225 (TOSHIBA CERAMICS CO LTD) 16.März 1987,
- PATENT ABSTRACTS OF JAPAN vol. 5 no. 176 (E-81) ,12.November 1981 & JP,A,56 103439 (IMANAKA SEIJI) 18.August 1981,
- PATENT ABSTRACTS OF JAPAN vol. 950 no. 2 & JP,A,07 037866 (FUJITSU LTD) 7.Februar 1995,

## Beschreibung

Die Erfindung betrifft ein Verfahren zum Feinstreinigen von Oberflächen mit Wasserdampf gemäß dem Oberbegriff des Anspruchs 1 und eine Vorrichtung zur Durchführung dieses Verfahrens gemäß dem Oberbegriff des Anspruchs 15.

Herkömmliche Reinigungsverfahren beruhen darauf, daß die zu reinigende Oberfläche des Gegenstandes oder des Substrats durch Tauchen ins Naßbecken, gefüllt mit Detergenzien und z.B. durch Ultraschall unterstützt oder durch Eintauchen der Substrate in Dampfatmosphären bzw. durch mechanische Bearbeitung der Oberflächen, z.B. durch Bürsten, durch Sprühen von Wasser oder Detergenzien mit Hochdruck aus Sprühdüsen oder durch Erregung durch Schwingungen (Megasonic) gereinigt werden.

Insbesondere bei der Chipherstellung ist die Planarisation ein Prozeßschritt, dem im Zuge der ständigen Verkleinerung von Strukturen immer größere Bedeutung zukommt. Die strukturierten Oberflächen eines Substrates (z.B. eines Silizium-Wafers) werden durch einen chemisch-mechanischen Polierschritt (chemical-mechanical polishing oder CMT-Prozeßschritt) eben geschliffen bzw. eben geläppt, wobei feine Schleifmittel (slurry) verwendet werden. Diese Schleifmittel weisen eine äußerst kleine Korngröße auf, was den Nachteil mit sich bringt, daß die einzelnen Schleifpartikel nach dem Schleifvorgang noch an der bearbeiteten Oberfläche anhaften und zum Teil in der Oberfläche eingelagert sind. Nach dem Schleifvorgang muß die Oberfläche zur weiteren Bearbeitung des Substrates vollständig von Schleifmittel und sonstigen Verunreinigungen befreit werden.

Wie bereits oben dargelegt wird mittels Bürsten, Wasser und Versprühen von Wasser mit Hochdruck bis zu 50 bar versucht, die Schleifmittelreste zu entfernen. Die Bürsten haben den wesentlichen Nachteil, daß sie ständig mit Wasser benetzt werden müssen und sich allmählich mit dem abgetragenen Schleifmittel zusetzen. Es ist daher erforderlich, die Bürsten regelmäßig zu ersetzen, was wiederum mit dem Nachteil verbunden ist, daß durch Eingriff in die Reinigungsstation beim Ersetzen der Bürsten die Reinigungsstation kontaminiert wird. Außerdem birgt die mechanische Bearbeitung der zu reinigenden Oberfläche mit den Bürsten die Gefahr, daß die Oberfläche beschädigt wird, insbesondere verkratzt wird. In der Regel folgt dem Reinigungsprozeß mit den Bürsten ein weiterer Reinigungsprozeß, bei dem Wasser unter Hochdruck versprüht wird. Um gute Ergebnisse zu erzielen, muß die zu reinigende Oberfläche eine gewisse Zeit besprüht und mehrmals abgefahren werden, was eine lange Reinigungsdauer zur Folge hat.

Nachfolgend sollen nochmals die Nachteile des herkömmlichen Verfahrens aufgelistet werden. Neben einem hohen Bürstenverschleiß und somit hohen Kosten für die Bürsten ist der häufige Bürstenwechsel mit einem notwendigen Eingriff in die Maschine und somit mit Maschinenstillstand verbunden. Durch das Zusetzen der Bürsten ist eine Beschädigung der Oberfläche durch Verkratzen zu befürchten und das permanente Naßhalten der Bürsten (Bürstenmaterial besteht aus PFA-Schwamm) ist mit einem hohen Verbrauch an deionisiertem Wasser (DI-Wasser) verbunden. Außerdem ist der Aufbau der Reinigungskammer mit Bürstenreinigung für beidseitige Substratreinigung kompliziert und teuer. Der Bürstenandruck der Schwammbürste ist nicht reproduzierbar einstellbar. Bei der Hochdruckreinigung besteht die Gefahr der elektrostatischen Aufladung des Substrats, da nicht leitfähiges Di-H₂O eingesetzt wird. Mit Megasonic ist die Oberfläche speziell nach Schleifprozessen nicht vollständig reinigbar.

Aus der EP 381 435 A2 ist ein Verfahren und eine Vorrichtung zum Waschen von Leiterplatten bekannt. Dabei wird Dampf mit einer Temperatur und einem Druck auf die Platten gesprüht, wobei der Dampf keine Phasenänderung durchführt.

Mit der JP-A-703 7866 ist eine Vorrichtung bekannt geworden, mit der ein Gegenstand einer Atmosphäre aus mit NO₂ angereichtertem Dampf ausgesetzt wird.

Der Erfindung liegt daher die Aufgabe zu Grunde, ein Verfahren und/oder eine Vorrichtung bereit zu stellen, mit der kontaminierte Oberflächen einfacher, preiswerter und schneller, sowie mit größerer Sicherheit gegen Beschädigung gereinigt werden können.

Diese Aufgabe wird erfindungsgemäß dadurch gelöst, daß beim eingangs genannten Verfahren wenigstens eine Dampfdüse in die unmittelbare Nähe der Oberfläche gebracht wird und daß der Dampf über die Düse gezielt auf die zu reinigende Oberfläche geleitet wird, wobei die zu reinigende Oberfläche gleichzeitig mit oder vor dem Besprühen mit Dampf mit Wasser benetzt wird.

Die erfindungsgemäße Vorrichtung weist den wesentlichen Vorteil auf, daß die zu reinigende Oberfläche mechanisch nicht bearbeitet wird und die anhaftenden und zu entfernenden Teilchen der Schleifpaste zum einen durch die über den Dampf eingebrachte Wärmeenergie gelockert werden. Die unterschiedliche Wärmeenergieaufnahme von Substrat und zu lösenden Partikeln und durch unterschiedliche Ausdehnungskoeffizienten hervorgerufene Verspannungen lockert sich die Verbindung von Partikel und Substrat, wodurch die Partikel von der zu reinigenden Oberfläche gelöst werden.

Wird an Stelle von überhitztem Dampf Naßdampf verwendet, werden die Partikel zusätzlich durch die Impulskraftübertragung gelockert. Dabei wird die kinetische Energie (Ultraschallenergie) beim Aufprall der Flüssigkeitströpfchen ausgenutzt. Ein weiterer Vorteil besteht darin, daß beim Einleiten von Dampf in einen auf der Oberfläche sich befindenden Wasserfilm das Wasser zum Teil örtlich verdampft, wobei die Dampfbläschen unmittelbar danach wieder kollabieren oder an der Wasserfilmoberfläche zerplatzen. Diese Impulsivkrafteinwirkung auf die Partikel führt ebenfalls zu einer Lockerung. Im Wasserfilm können die Partikel auf der Oberfläche aufschwimmen und sind dadurch leicht zu entfernen. Der Wasserfilm kann entweder gesondert aufgetragen werden oder sich aus Kondensat bilden.

Das erfindungsgemäße Verfahren ist nicht nur einsetzbar bei ebenen bzw. planen Oberflächen sondern auch bei tiefen Strukturen, wie sie z.B. bei der Herstellung von Mikromechanikelementen vorkommen. Der Abtransport der gelösten Partikel kann entweder durch den auf die Oberfläche aufgeleiteten Dampf, durch Kondensat und/oder durch zusätzlich aufgesprühtes Wasser erfolgen. Insbesondere bei sehr dünnen Substraten ist dies von Vorteil, da dort nur eine geringe Kondensation stattfindet.

Bei einer Weiterbildung ist vorgesehen, daß z.B. durch Einleitung von Fremdgas, z.B. Stickstoff o.dgl., oder durch Verwendung von Heißdampf die Oberfläche abschließend getrocknet werden kann. Trocknungsflecken werden auf diese Weise vermieden. Als besonders wichtig wird angesehen, daß die Ablösung der Teilchen durch Impulskrafteinwirkung (kinetische Energie), durch unterschiedliche Wärmeausdehnung (thermische Energie) und durch Impulsivkrafteinwirkung (Verdampfen von Wasser und Zerplatzen der Gasbläschen) bewirkt wird. Dabei wird das Einblasen von Dampf in einen Wasserfilm bevorzugt.

Vorteile werden darin gesehen, daß DI-Wasser verwendet wird, welchem Alkohole, Detergenzien, Lösemittel o.dgl. zugesetzt sein können. Dem Dampf können Fremdgase, z.B. Stickstoff o.dgl. zugesetzt sein. Ein besonderes Anwendungsgebiet wird in der dem CMP-Prozeß nachfolgenden Reinigung gesehen, jedoch auch bei der Herstellung von LCD-Produkten, bei der Harddiskfertigung, der Mikromechanik oder anderen Prozessen, die hochreine Oberflächen benötigen.

Die eingangs genannte Aufgabe wird mit einer Vorrichtung erfindungsgemäß dadurch gelöst, daß wenigstens eine auf eine zu reinigende Oberfläche gerichtete Dampfdüse sowie eine Einrichtung zum Erzeugen eines Wasserfilms auf der zu reinigenden Oberfläche vorgesehen sind.

Bei dieser Vorrichtung wird z.B. die Oberfläche eines Silizium-Wafers mit Wasser benetzt, wobei anschließend in diesen Wasserfilm Dampf eingeblasen wird. Die Oberfläche wird mittels dieser erfindungsgemäßen Vorrichtung berührungslos gereinigt, wobei die o.g. Kräfte den Hauptbeitrag zur Ablösung der Schmutzpartikel bilden. Die Benutzung mit Wasser kann z.B. durch Aufsprühen von Dampf erfolgen, der dann kondensiert.

Erfindungsgemäß ist eine Transportvorrichtung vorgesehen, mittels der die Gegenstände bzw. Substrate, deren Oberfläche gereinigt werden muß, rotiert und/oder transportiert werden. Die Gegenstände sind z.B. flache Scheiben bei Silizium-Wafern, die berührungslos im Durchlaufverfahren durch die Reinigungsstation hindurchtransportiert werden. Dabei wird sowohl die Oberseite als auch die Unterseite gereinigt. Die beiden Seiten können gleichzeitig oder nacheinander gereinigt werden. Vorzugsweise rotiert dabei der Gegenstand auf einem Dampf- und/oder Wasserkissen und wird auf diese Weise berührungslos gehalten. Die Position wird über am Rand der Scheibe angreifenden Stiften oder Rollen fixiert. Durch entsprechend angeordnete Düsen an der Transportvorrichtung, die in Richtung der Unterseite der Scheibe gerichtet sind, wird das Substrat in Rotation versetzt und/oder durch die Reinigungsstation hindurchtransportiert. Der schräge Auftreffwinkel des die Düsen verlassenden Fluides ist derart gewählt, daß die Scheibe auf jeden Fall bewegt wird, ggf. zusätzlich noch gereinigt wird. Das auftreffende Fluid dient also als Transportmedium, als Reinigungsmedium und als Abtransportmedium für abgelöste Partikel. Der Abfluß des Fluides wird z.B. über Quernuten bzw. schräg verlaufende Nuten in der Transportvorrichtung erleichtert.

An den Abschnitt der Reinigungsstation, in dem die Reinigung stattfindet, kann sich ein Trocknerabschnitt anschließen, in dem das Substrat getrocknet wird. Dabei wird das Substrat bevorzugt in Drehung versetzt (1500 U/min), wodurch der anhaftende Wasserfilm abgeschleudert wird, außerdem kann die Trocknung noch durch Heißdampf unterstützt werden. Am Ausgang der Reinigungsstation können die einzelnen Substrate zum Abtransport in Magazine oder Kassetten eingeführt werden.

Die Vorteile des erfindungsgemäßen Verfahrens und der erfindungsgemäßen Vorrichtung sind die wesentlich besseren Reinigungsergebnisse bei höheren Wassertemperaturen, kürzere Prozeßzeiten und damit verbundene höhere Durchsätze, kontaktloses Reinigen und damit keine mechanische Beanspruchung der Substratoberfläche, keine Verbrauchsmaterialien, wie Bürsten etc. und dadurch erheblich geringere Betriebskosten, keine Eingriffe in die Reinigungskammer und dadurch keine Stillstandzeiten und Gefahr der Kontamination, keine Reinigung der Prozeßkammer erforderlich, da diese automatisch mit dem Dampf mitgereinigt wird, kleinere Anlagenabmessungen und kleinerer Reinraumbedarf, einfacherer Prozeßkammeraufbau, reprodzierbare Reinigungsergebnisse im Gegensatz zum herkömmlichen Verfahren, bei dem sich die Bürsten abnutzen, einfach integrierbar in Cluster mit anderen Anlagen, umweltfreundliche Reinigung, da keine Lösemittel, z.B. bei Reinigung des Polishers im CMP-Prozeß.

Weitere Vorteile, Merkmale und Einzelheiten der Erfindung ergeben sich aus den Ansprüchen sowie aus der nachfolgenden Beschreibung, in der unter Bezugnahme auf die Zeichnung besonders bevorzugte Ausführungsbeispiele im einzelnen dargestellt sind. Dabei können die in den Ansprüchen und in der Beschreibung erwähnten und die in der Zeichnung dargestellten Merkmale jeweils einzeln für sich oder in beliebiger Kombination erfindungswesentlich sein. In der Zeichnung zeigen:
- Figur 1: eine Prinzipskizze einer Vorrichtung zum Erzeugen des Dampfes;
- Figur 2: einen Verfahrensablauf zur Beschichtung und Planarisierung eines Silizium-Wafers;
- Figur 3: eine erste Ausführungsform der erfindungsgemäßen Reinigungsvorrichtung;
- Figur 4: eine zweite Ausführungsform der erfindungsgemäßen Reinigungsvorrichtung;
- Figur 5: eine erste Ausführungsform der erfindungsgemäßen Transportvorrichtung;
- Figur 6: eine zweite Ausführungsform der erfindungsgemäßen Transportvorrichtung;
- Figur 7: eine Draufsicht auf die Vorrichtung gemäß Figur 6 in Richtung des Pfeils VII;
- Figur 8: eine dritte Ausführungsform der erfindungsgemäßen Transportvorrichtung;
- Figur 9: eine vierte Ausführungsform der erfindungsgemäßen Transportvorrichtung;
- Figur 10: eine fünfte Ausführungsform der erfindungsgemäßen Transportvorrichtung;
- Figur 11: eine Prinzipdarstellung einer Reinigungsstation;
- Figur 12: eine Darstellung eines ersten Verfahrens zur Reinigung kontaminierter Oberflächen;
- Figur 13: ein zweites Verfahren zur Reinigung kontaminierter Oberflächen;
- Figur 14: ein drittes Verfahren zur Reinigung kontaminierter Oberflächen;
- Figur 15: eine Draufsicht auf die Darstellung gemäß Figur 14 in Richtung des Pfeils XV.

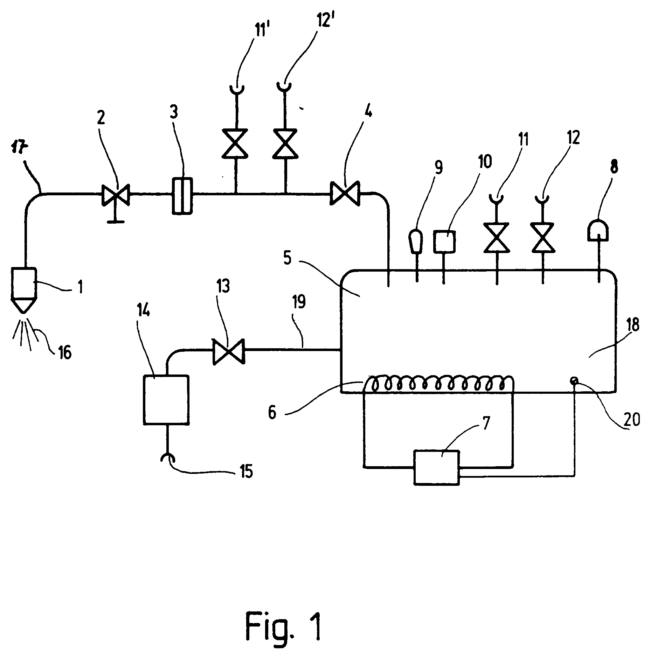

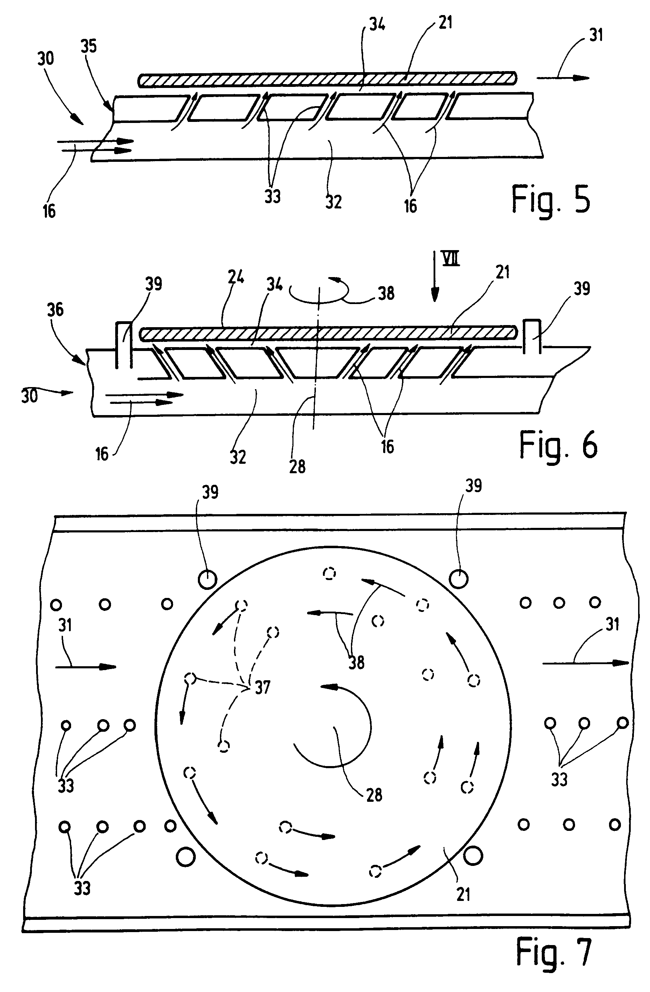

In der Figur 1 ist eine Prinzipskizze zur Aufbereitung des für die Reinigung kontaminierter Oberflächen zu verwendenden Dampfes dargestellt. Dabei ist mit dem Bezugszeichen 1 eine Sprühdüse bezeichnet, aus welcher der Dampf 16 als überhitzter Dampf oder Naßdampf austritt. Die Düse 1 ist über eine Leitung 17 mit einem Dampfkessel 5 verbunden. Dabei sind in der Leitung 17 nacheinander ein Dampfventil 4, ein Anschluß 12' für Fremdgaseinführung, z.B. zur Einführung von Stickstoff (N₂), ein Anschluß 11' für Fremdmitteleinführung, z.B. Alkohol o.dgl., ein Feinstfilter 3 sowie ein Durchflußminderer 2, z.B. in Form einer Drossel vorgesehen. Im Dampfkessel 5 befindet sich deionisiertes Wasser 18, welches entweder über einen direkten Wassereinlauf 8, z.B. bei nicht-kontinuierlichem Betrieb, oder über einen Zulauf 19 eingeleitet wird. Dieser Zulauf 19 ist mit einem Wasseranschluß 15 sowie mit einer Wasserdruckpumpe 14 und einem Wassereinlaufventil 13 für den kontinuierlichen Betrieb verbunden. Im Wasserbad des Dampfkessels 5 befindet sich eine Heizung 6, insbesondere eine elektrische Heizung, mittels welcher das Wasserbad über einen Heizungsregler 7 mit einem Temperatursensor 20 beheizt wird. Der Dampfkessel 5 ist außerdem mit einem Anschluß 12 für Fremdgaseinführung sowie einem Anschluß 11 für Fremdmitteleinführung, einem Dampfdruckschalter 10, sowie einem Überdruckventil 9 versehen. Auf diese Weise kann sowohl überhitzter Dampf als auch Naßdampf, z.B. durch Zuführung von Wasser über den Anschluß 11', erzeugt werden.

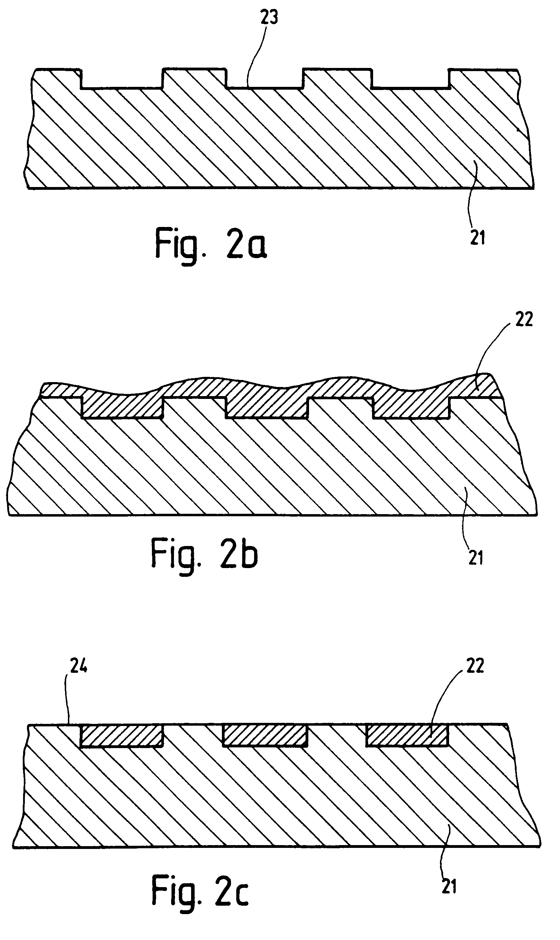

Bei der Waferherstellung wird die strukturierte Oberfläche eines Silizium-Wafers 21 mit einer Planarisierungsschicht, die z.B. aus SiO₂ besteht, beschichtet. Die strukturierte Oberfläche, die durch Belichtung und ein anschließendes Ätzverfahren hergestellt worden ist, ist in Figur 2a dargestellt. Die Figur 2b zeigt die mit der Planarisierungsschicht 22 überzogene Oberfläche, wobei deutlich erkennbar ist, daß die Oberfläche dieser Planarisierungsschicht 22 nicht eben ist. Über einen sich daran anschließenden Schleif- bzw. Läpp-Prozeß (CMP-Prozeß) wird die Planarisierungsschicht 22 so weit abgeschliffen, bis lediglich noch die Vertiefungen 23 der Oberfläche des Silizium-Wafers 21 angefüllt sind. Dabei werden hochfeine Schleifmittel (slurry) verwendet, wobei aber die einzelnen Schleifmittelteilchen nach Beendigung des Schleifprozesses noch an der Oberfläche anhaften bzw. in Vertiefungen der Oberfläche 60 eingelagert sind. Die in der Figur 2c dargestellte und mit 24 bezeichnete Oberfläche muß nun für weitere Prozesse dekontaminiert, d.h. von jeglicher Verunreinigung befreit werden.

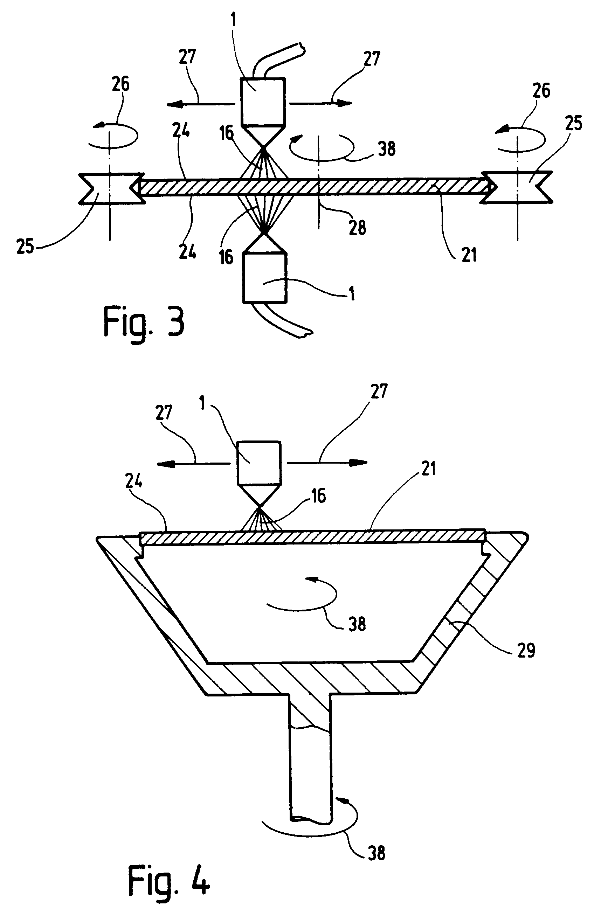

Die Figur 3 zeigt ein erstes Ausführungsbeispiel der erfindungsgemäßen Reinigungsvorrichtung, die z.B. zur Aufnahme von Silizium-Wafern 21, die eine runde scheibenförmige Gestalt aufweisen, ausgebildet ist. Der Silizium-Wafer 21 bzw. das Substrat 21, ist im Bereich der Kanten in wenigstens drei diaboloförmigen Antriebsrollen 25 eingespannt, wobei die Antriebsrollen in Richtung des Pfeils 26 drehbar gelagert sind. Auf diese Weise kann das Substrat 21 ohne Beschädigung und ohne Berührung der Oberfläche 24 bewegt werden. Dabei werden die beiden Oberflächen 24 von oben bzw. von unten über Sprühdüsen 1 mit Dampf 16 besprüht. Die Sprühdüse 1 ist jeweils über eine geeignete Vorrichtung radial in Richtung der Pfeile 27 oder auf andere Weise zwischen dem Zentrum 28 und der Kante des Substrats 21 verfahrbar und weisen einen Abstand von ca. 1 mm zur Oberfläche 24 auf. Dadurch kann die gesamte Oberfläche 24 mit Dampf 16 bearbeitet werden.

Der aus der Düse 1 austretende Dampf 16 prallt auf die Oberfläche 24, so daß durch die kinetische Energie die auf bzw. in Vertiefungen der Oberfläche 24 anhaftenden Verunreinigungen gelockert werden. Wird Naßdampf 16 auf die Oberfläche aufgesprüht, dann werden die Verunreinigungen durch die auftreffenden Flüssigkeitströpfchen bzw. durch deren kinetische Energie gelockert. Außerdem kondensiert der Wasserdampf auf der Oberfläche und wird durch nachfolgenden Dampf teilweise wieder verdampft, wobei die Dampfblasen unmittelbar darauf wieder kollabieren oder an der Oberfläche des Substrats zerplatzen. Diese Impulsivkräfte führen zu einer weiteren Lockerung der Partikel. Außerdem werden das Substrat 21 und die einzelnen Partikel unterschiedlich erwärmt, so daß es zu Wärmespannungen kommt, die eine weitere Lockerung verursachen.

Der Vorteil dieses erfindungsgemäßen Verfahrens liegt im sehr geringen Medienverbrauch, wobei die Impuls-, Wärme- und Impulsivkräftewirkung ein sehr effektives Reinigen bewirken. Außerdem ist die Reinigungskraftwirkung durch gezielte Veränderung des Dampfdrucks, Dampfanstrittsmenge, Dampftemperatur, Abstand zwischen Dampfdüse und Substratoberfläche und Dicke des Wasserfilms sowie durch Fremdmitteldosierung bzw. Fremdgasdosierung leicht steuerbar. Die Reinigung erfolgt mittels deionisiertem Wasser, so daß keine Entsorgungsprobleme entstehen und das gesamte Verfahren umweltfreundlich ist. Die Trocknung kann durch Aufblasen von Heißdampf 16 erfolgen oder durch Fremdgaszufuhr. Die Druckregelung erfolgt durch die Temperatur des Wassers im Temperaturbereich ab 100°C bis etwa 200°C, was einem Druckbereich bis ca. 10 bar entspricht.

Die Figur 4 zeigt eine andere Ausführungsform der erfindungsgemäßen Reinigungsvorrichtung, in welcher das Substrat 21 in einen Drehhalter 29 eingespannt ist. Dieser Drehhalter 29 kann auch nicht kreisrunde Substrate 21 aufnehmen, und erfaßt diese im Bereich deren Kante. Bei dieser Ausführungsform wird mittels der Düse 1 die nach oben weisende Oberfläche 24 gereinigt.

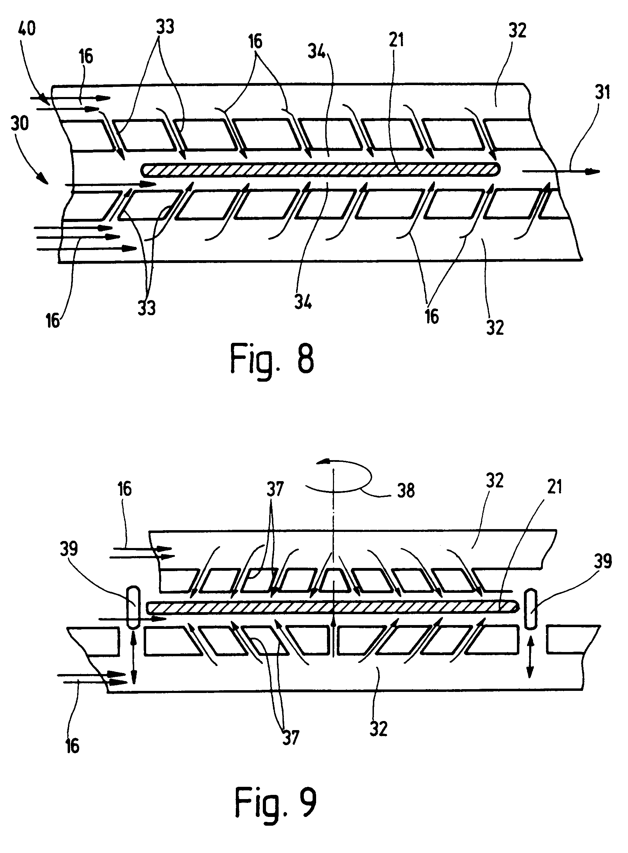

Die Figur 5 zeigt eine erste Ausführungsform einer Transportvorrichtung 30 zum Bewegen des Substrats 21 in Richtung des Pfeils 31. Hierfür weist die Transportvorrichtung 30 einen Dampfkanal 32 auf, der an seiner Oberseite mit einer Vielzahl von Dampfdüsen 33 versehen ist. Diese Dampfdüsen 33 sind geringfügig in Richtung des Pfeils 31 geneigt, so daß aus dem Dampfkanal 32 austretender Dampf 16 ein Dampfkissen 34 unter dem Substrat 21 bildet und dieses in Richtung des Pfeils 31 transportiert. Auf diese Weise kann das Substrat 21 im Durchlaufverfahren durch eine Reinigungsstation berührungslos bewegt werden, wobei das Substrat 21 auf einem Dampf-Wasser-Kissen 34 schwebt. Die seitliche Führung erfolgt über Begrenzungsleisten, wie in Figur 7 dargestellt.

Die Transportvorrichtung 30 weist neben Transportabschnitten, die in der Figur 5 dargestellt sind, auch Abschnitte 36 auf, in denen das Substrat 21 gedreht wird, was in Figur 6 dargestellt ist. In diesen Abschnitten 36 sind ebenfalls Dampfdüsen 37 vorgesehen, deren Austrittsrichtung jedoch im wesentlichen nach oben geneigt und tangential um das Zentrum 28 und ggf., wie in Figur 6 dargestellt, nach außen in Richtung der Kante des Substrats 21 geneigt verläuft. Auf diese Weise wird das Substrat in Richtung der Pfeile 38 um das Zentrum 48 gedreht. Die Positionierung des Substrats 21 erfolgt über Begrenzungsbolzen 39, die versenkbar im Abschnitt 36 angeordnet sind. Sind die Begrenzungsbolzen 39, wie in den Figuren 6 bzw. 7 dargestellt, ausgefahren, dann wird das Substrat 21 am Weitertransport in Richtung des Pfeils 31 gehindert und im Abschnitt 36 festgehalten. Die Begrenzungsbolzen 39 können auch ihrerseits drehbar gelagert sein. In diesem Abschnitt 36 kann dann die Reinigung der Oberfläche(n) 24 des Substrats 21 erfolgen.

Die Figur 8 zeigt eine modifizierte Ausführungsform eines Transportabschnitts 40 einer Transporteinrichtung 30, wobei das Substrat 21 im wesentlichen zwischen zwei Dampfkanälen 32 angeordnet ist, und beide Oberflächen mit aus Dampfdüsen 39 austretendem Dampf 16 beaufschlagt werden. Das Substrat 21 ist somit zwischen zwei Dampfkissen 34 eingebettet und wird in Richtung des Pfeils 31 bewegt.

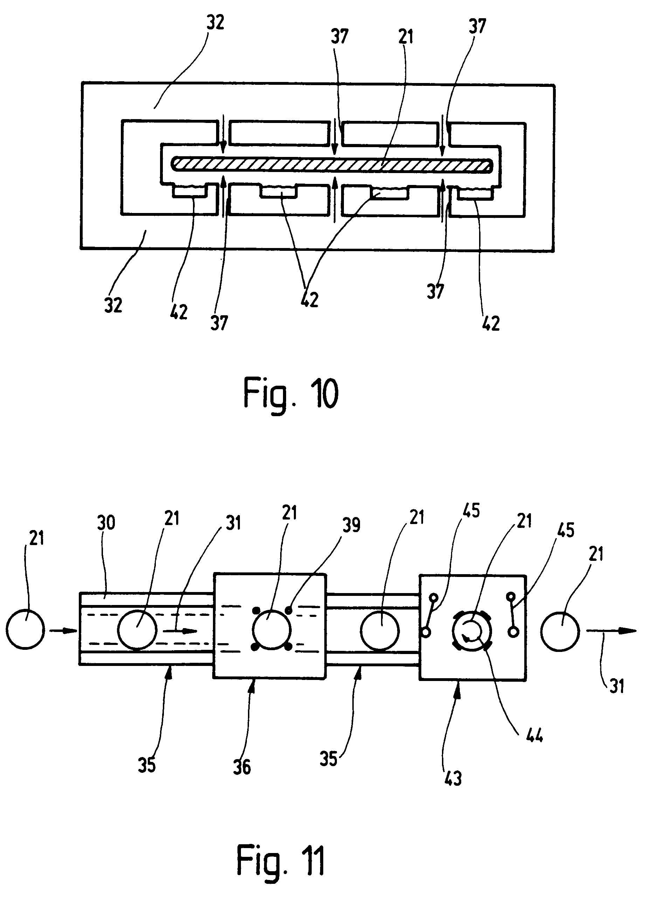

In der Figur 9 ist ein alternativer Reinigungsabschnitt 41 der Transportvorrichtung 30 dargestellt, in dem das Substrat 21 wie zu den Figuren 6 und 7 beschrieben, über die Begrenzungsstifte 39 festgehalten und mittels der Dampfdüsen 37 gedreht wird. Dabei können die Dampfdüsen 37, wie bereits auch beim Ausführungsbeispiel der Figuren 6 und 7, gleichzeitig als Sprühdüsen 1, d.h. zur Reinigung der Oberflächen 24 des Substrats 21 dienen. Die abgelösten Schmutzpartikel und das anfallende Wasser kann, wie in der Figur 10 dargestellt, über Kanäle 42, die im unteren Dampfkanal 32 vorgesehen sind, abgeführt werden. Hierfür sind die Kanäle 32 und/oder 42 geneigt angeordnet.

Die Figur 11 zeigt in schematischer Weise eine derartige Durchlaufeinrichtung, in der das Substrat 21 auf die Transportvorrichtung 30 aufgesetzt und in Richtung des Pfeils 31 transportiert wird. Dabei dient der Abschnitt 35 zum Transport und der Abschnitt 36 zur Reinigung des Substrats 21. Mit 43 ist in schematischer Weise ein Spintrockner dargestellt, in welchem das Substrat 21 in eine schnelle Rotation in Richtung des Pfeils 44 (etwa 1500 U/min) versetzt wird. Über entsprechende Manipulatoren 45 wird das Substrat 21 aus dem Spintrockner 43 entnommen und z.B. in Kassetten oder Magazinen (nicht dargestellt) abgelegt und für den Weitertransport in Richtung des Pfeils 31 vorbereitet.

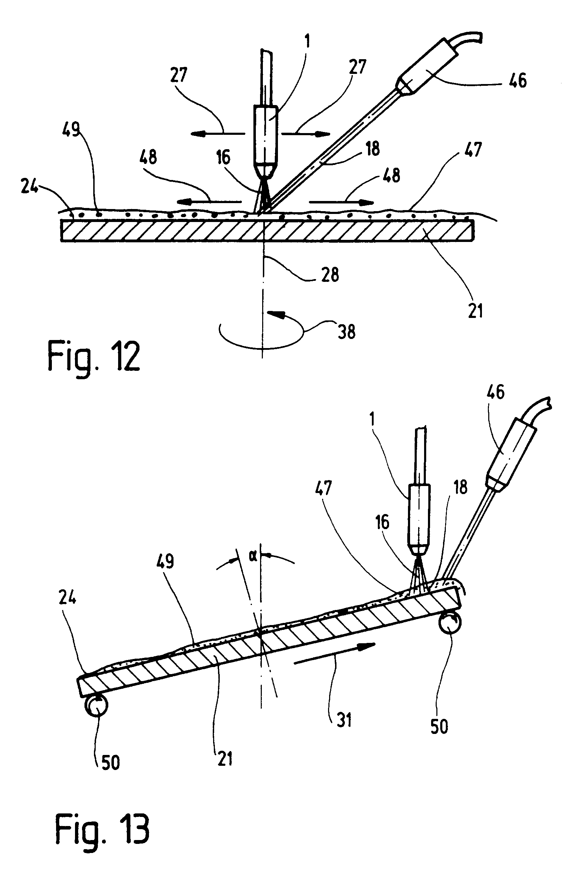

In Figur 12 ist ein Reinigungsverfahren dargestellt, bei dem das Substrat 21 über eine Wasserlanze 46 mit Wasser 18 besprüht wird, so daß ein Wasserfilm 47 auf der Oberfläche 24 des Substrats 21 entsteht. Über die Wasserlanze 46 wird das Wasser 18 im Zentrum 28 auf die Oberfläche 24 aufgegeben, so daß das Wasser 18 als Wasserfilm 47 in Richtung der Pfeile 48 abläuft. Gleichzeitig fährt die Sprühdüse 1 in Richtung der Pfeile 27 über die Oberfläche 24 und sprüht den Dampf 16 direkt in den Wasserfilm 47. Dabei bilden sich im Wasserfilm 47 Dampfblasen, die entweder sofort wieder kollabieren oder an der Oberfläche des Wasserfilms 47 zerplatzen. Neben der Impulswirkung des Wasserdampfs 16 erfahren die Partikel 49 auch die Impulsivwirkung dieser Dampfblasen, und werden auf diese Weise von der Oberfläche 24 gelockert oder abgelöst. Sie werden dann mit dem abfließenden Wasserfilm 47 abtransportiert.

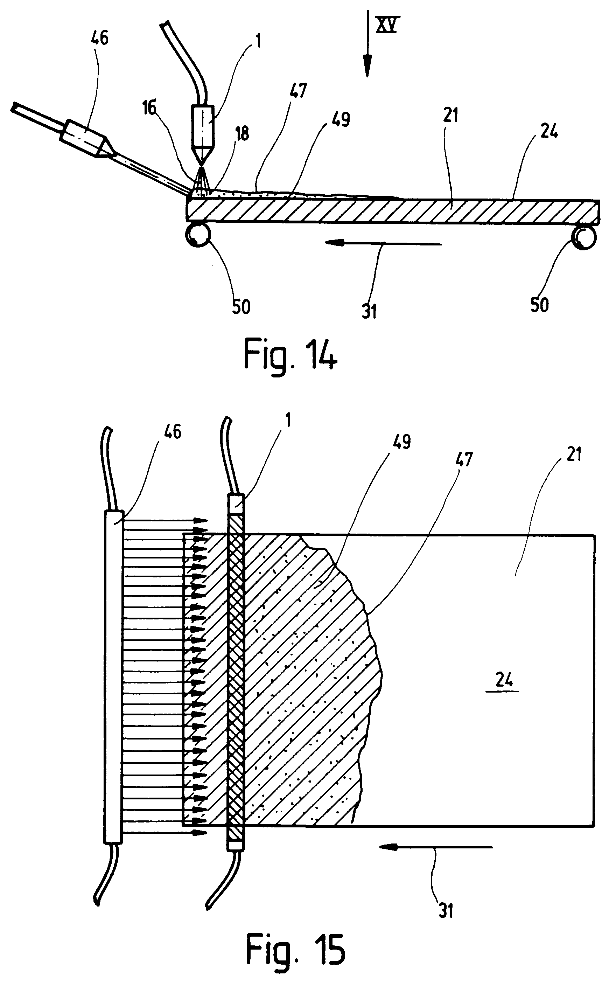

Bei der Ausführungsform der Figur 13 ist das Substrat 21 um einen Winkel α geneigt angeordnet und wird über Transportrollen 50, von denen lediglich zwei dargestellt sind, in Richtung des Pfeils 31 transportiert. Auch hier wird über die Wasserlanze 46 Wasser 18 zur Bildung eines Wasserfilms 47 auf die Oberfläche 24 des Substrats 21 aufgetragen. In diesen Wasserfilm 47 wird über die Sprühdüse 1 Wasserdampf 16, wie beim Ausführungsbeispiel der Figur 12, eingeblasen. Die Sprühdüse 1 wird dabei orthogonal zur Zeichenebene bewegt oder die Sprühdüse 1 kann als Breitschlitzdüse ausgebildet sein, wie in Figur 15 dargestellt.

Beim Ausführungsbeispiel der Figur 14 ist das Substrat 21 eben angeordnet und wird ebenfalls über Rollen 50 in Richtung des Pfeils 31 transportiert. Auch hier wird über die Lanze 46 Wasser 18 zur Bildung eines Wasserfilms 47 auf die Oberfläche 24 aufgetragen und in den Wasserfilm 47 über die Düse 1 Dampf 16 eingeblasen. Die Draufsicht, die in Figur 15 dargestellt ist, zeigt, daß sowohl die Wasserlanze 46 als auch die Düse 1 als Breitschlitzdüsen ausgebildet sind. Diese Anordnung eignet sich hervorragend für das Durchlaufverfahren, wobei das Substrat 21 schonend behandelt wird.

Abschließend wird noch darauf hingewiesen, daß dieses Verfahren und eine derartige Vorrichtung bei bestehenden Schleifanlagen problemlos nachgerüstet werden können und bestehende Reinigungsvorrichtungen ohne weiteres ersetzen können.

## Patentansprüche

1. Verfahren zum Feinstreinigen von kontaminierten Oberflächen (24) mit Wasser (18) und Wasserdampf (16) bei dem die zu reinigende Oberfläche (24) aus unmittelbarer Nähe aus wenigstens einer Dampfdüse (1) mit Dampf (16) beaufschlagt wird, **dadurch gekennzeichnet**, daß vor dem und während des Dampfstrahlens (16) ein Wasserfilm (47) durch eine separate Einrichtung aufgebracht wird und die Dampfdüse (1) den Dampf (16) gezielt in diesen auf der Oberfläche (24) sich befindenden Wasserfilm (47) und durch ihn hindurch auf die zu reinigende Oberfläche (24) leitet.

2. Verfahren nach Anspruch 1, dadurch gekennzeichnet, daß überhitzter Dampf (16) oder Naßdampf (16) verwendet wird.

3. Verfahren nach einem der vorhergehenden Ansprüche, dadurch gekennzeichnet, daß deionisiertes Wasser (18) verwendet wird.

4. Verfahren nach einem der vorhergehenden Ansprüche, dadurch gekennzeichnet, daß dem Dampf (16) und/oder dem Wasser (18) ein anderes Gas, z.B. Stickstoff (N₂), und/oder eine andere Flüssigkeit, z.B. Alkohole, Detergenzien usw., zugesetzt werden.

5. Verfahren nach einem der vorhergehenden Ansprüche, dadurch gekennzeichnet, daß die Zusammensetzung des Dampfes (16) und/oder des Wassers (18) während des Reinigungsprozesses geändert wird.

6. Verfahren nach einem der vorhergehenden Ansprüche, dadurch gekennzeichnet, daß der Reinigungsprozeß vom Zentrum (28) der zu reinigenden Oberfläche (24) in Richtung deren Kante erfolgt.

7. Verfahren nach einem der vorhergehenden Ansprüche, dadurch gekennzeichnet, daß die zu reinigende Oberfläche (24) in Drehung versetzt wird.

8. Verfahren nach einem der vorhergehenden Ansprüche, dadurch gekennzeichnet, daß der Dampf (16) und/oder das Wasser (18) orthogonal zur Oberfläche (24) oder schräg in Richtung deren Kante auf die Oberfläche (24) aufgebracht wird.

9. Verfahren nach einem der vorhergehenden Ansprüche, dadurch gekennzeichnet, daß nach dem Reinigungsprozeß die Oberfläche (24) durch Heißluft und/oder Heißdampf (16) oder über eine Spin-Trockenschleuder getrocknet wird.

10. Verfahren nach einem der vorhergehenden Ansprüche, dadurch gekennzeichnet, daß die Reinigung der kontaminierten Oberfläche (24) in einer Reinigungsstation, insbesondere einer Durchlaufstation erfolgt.

11. Verfahren nach einem der vorhergehenden Ansprüche, dadurch gekennzeichnet, daß der Dampf (16) mit einem Druck bis zu 10 bar auf die Oberfläche (24) gesprüht wird.

12. Verfahren nach einem der vorhergehenden Ansprüche, dadurch gekennzeichnet, daß es bei CMP-Prozessen, der Maskenfertigung, der Filmherstellung, der LCD-Produktion, der Harddiskfertigung, der Mikromechanik, Leseköpfe für Harddisks usw. eingesetzt wird.

13. Vorrichtung zur Durchführung eines Verfahrens nach einem der vorhergehenden Ansprüche, mit wenigstens einer auf die zu reinigende Oberfläche (24) gerichteten Dampfdüse (1) sowie mit einer von der Dampfdüse (1) separaten Sprühdüse (46) zum Erzeugen eines Wasserfilms (47) auf der zu reinigenden Oberfläche (27), wobei die Sprühdüse (46) und die Dampfdüse (1) auf die zu reinigende Oberfläche ausgerichtet sind.

14. Vorrichtung nach Anspruch 13, dadurch gekennzeichnet, daß eine Transportvorrichtung (30) für die die zu reinigende Oberfläche (24) aufweisenden Gegenstände, insbesondere flache scheibenförmigen Gegenstände (21), vorgesehen ist.

15. Vorrichtung nach Anspruch 14, dadurch gekennzeichnet, daß diese Transportvorrichtung (30) die Gegenstände (21) berührungslos transportiert.

16. Vorrichtung nach Anspruch 14 oder 15, dadurch gekennzeichnet, daß die Transportvorrichtung (30) die Gegenstände (21) in Rotation versetzt und/oder durch eine Reinigungsstation transportiert.

17. Vorrichtung nach einem der Ansprüche 14 bis 15, dadurch gekennzeichnet, daß die Transportvorrichtung (30) an ihrer Oberseite Dampf- und/oder Flüssigkeitsdüsen (33, 37) aufweist, die zur Erzeugung eines Transportkissens (34) für den Gegenstand (21) dienen.

18. Vorrichtung nach Anspruch 17, dadurch gekennzeichnet, daß die Austrittsrichtung der Düsen (33, 37) in Transport- oder Rotationsrichtung weisen.

19. Vorrichtung nach einem der Ansprüche 14 bis 18, dadurch gekennzeichnet, daß die Transportvorrichtung (30) eine insbesondere wasserführende Einrichtung (42) aufweist, mit der die abgelösten Verunreinigungen (49) abgeführt werden.

20. Vorrichtung nach einem der Ansprüche 14 bis 19, dadurch gekennzeichnet, daß die Transportvorrichtung (30) mit Dampf (16) führenden Reinigungsdüsen (37) versehen ist.

21. Vorrichtung nach einem der Ansprüche 14 bis 20, dadurch gekennzeichnet, daß die Transportvorrichtung (30) seitlich am Gegenstand (21) angreifende, insbesondere versenkbare Halteelemente (39), z.B. Stifte, Rollen o.dgl. aufweist.

22. Vorrichtung nach einem der Ansprüche 13 bis 21, dadurch gekennzeichnet, daß die Sprühdüse (46) und/oder die Dampfdüse (1) eine Breitschlitzdüse ist.

23. Vorrichtung nach einem der Ansprüche 13 bis 22, dadurch gekennzeichnet, daß die Sprühdüse (46) und die Dampfdüse (1) im wesentlichen auf die gleiche Position auf der zu reinigenden Oberfläche (24) ausgerichtet sind.

24. Vorrichtung nach einem der Ansprüche 13 bis 23, dadurch gekennzeichnet, daß die Dampfdüse (1) und/oder die Sprühdüse (26) verschwenkbar und/oder verfahrbar sind.

## Claims

1. A method for super-cleaning of contaminated surfaces (24) with water (18) and water vapor (16), in which the surface (24) to be cleaned is acted upon from its immediate vicinity by steam (16) from at least one steam nozzle (1), characterized in that before and during the steam spraying (16), a water film (47) is applied through a separate device, and the steam nozzle (1) carries the steam (16) in a targeted fashion into this water film (47) located on the surface (24) and through this film onto the surface (24) to be cleaned.

2. The method of claim 1, characterized in that superheated steam (16) or wet steam (16) is used.

3. The method of one of the foregoing claims, characterized in that deionized water (18) is used.

4. The method of one of the foregoing claims, characterized in that some other gas, such as nitrogen (N₂) and/or some other liquid, such as alcohols, detergents, etc., are added to the steam (16) and/or to the water (18).

5. The method of one of the foregoing claims, characterized in that the composition of the steam (16) and/or water (18) is varied during the cleaning process.

6. The method of one of the foregoing claims, characterized in that the cleaning process takes place from the center (28) of the surface (24) to be cleaned toward its edge.

7. The method of one of the foregoing claims, characterized in that the surface (24) to be cleaned is set into rotation.

8. The method of one of the foregoing claims, characterized in that the steam (16) and/or the liquid (18) is applied to the surface (24) orthogonally to the surface (24) or obliquely in the direction of its edge.

9. The method of one of the foregoing claims, characterized in that after the cleaning process, the surface (24) is dried by hot air and/or hot steam (16) or via a spin dryer.

10. The method of one of the foregoing claims, characterized in that the cleaning of the contaminated surface (24) takes place in a cleaning station, in particular a once-through station.

11. The method of one of the foregoing claims, characterized in that the steam (16) is sprayed onto the surface (24) at a pressure of up to 10 bar.

12. The method of one of the foregoing claims, characterized in that it is employed in CMP processes, mask production, film production, LCD production, hard-disk manufacture, micro-mechanics, reading heads for hard disks, and so forth.

13. A device for performing a method of one of the foregoing claims, having at least one steam nozzle (1) aimed at the surface (24) to be cleaned and having a spray nozzle (46), separate from the steam nozzle (1) for creating a water film (47) on the surface (27) to be cleaned, wherein the spray nozzle (46) and the steam nozzle (1) are aimed at the surface to be cleaned.

14. The device of claim 13, characterized in that a transport device (30) is provided for the articles, in particular flat disklike articles (21), having the surface (24) to be cleaned.

15. The device of claim 14, characterized in that this transport device (30) transports the articles (21) without touching them.

16. The device of claim 14 or 15, characterized in that the transport device (30) sets the articles (21) into rotation and/or transports them through a cleaning station.

17. The device of one of claims 14-15, characterized in that the transport device (30) has steam and/or liquid nozzles (33, 37) on its top, which serve to create a transport cushion (34) for the article (21).

18. The device of claims 16 and 17, characterized in that the exit direction of the nozzles (33, 37) points in the transport or rotation direction.

19. The device of one of claims 14-18, characterized in that the transport device (30) has an in particular water-carrying device (42) with which the detached contaminants (49) are removed.

20. The device of one of claims 14-19, characterized in that the transport device (30) is provided with cleaning nozzles (37) that carry steam (16).

21. The device of one of claims 14-20, characterized in that the transport device (30) has retaining elements (39), such as pins, rollers or the like, that engage the article (21) laterally and in particular can be lowered.

22. The device of one of claims 13-21, characterized in that the spray nozzle (46) and/or the steam nozzle (1) is a wide-slit nozzle.

23. The device of one of claims 13-22, characterized in that the spray nozzle (46) and the steam nozzle (1) are aimed at substantially the same position on the surface (24) to be cleaned.

24. The device of one of claims 13-23, characterized in that the spray nozzle (1) and/or the device for creating a water film (47) is pivotable and/or movable.

## Revendications

1. Procédé pour le nettoyage approfondi de surfaces contaminées (24) avec de l'eau (18) et de la vapeur (18), dans lequel les surfaces à traiter (24) sont soumises, à proximité immédiate, à l'action de la vapeur au moyen d'au moins d'une buse de vapeur (1), **caractérisé en ce que**, avant et pendant la projection de vapeur (16), on amène une pellicule d'eau (47) au moyen d'un dispositif séparé et que la buse de vapeur (1) guide la vapeur (16) dans cette pellicule d'eau (47) se trouvant sur la surface à traiter (24) et, à travers cette dernière sur la surface à traiter (24).

2. Procédé selon la revendication 1, caractérisé en ce que l'on utilise de la vapeur surchauffée (16) ou de la vapeur saturée (16).

3. Procédé selon l'une quelconque des revendications précédentes, caractérisé en ce que l'on utilise de l'eau désionisée.

4. Procédé selon l'une quelconque des revendications précédentes, caractérisé en ce que l'on ajoute un autre gaz, par exemple de l'azote (N₂) et/ou un autre liquide, par exemple des alcools, des détergents, etc. à la vapeur (16) et/ou à l'eau (18).

5. Procédé selon l'une quelconque des revendications précédentes, caractérisé en ce que l'on modifie la composition de la vapeur (16) et/ou de l'eau (18) pendant la processus de nettoyage.

6. Procédé selon l'une quelconque des revendications précédentes, caractérisé en ce que le processus de nettoyage est réalisé à partir du centre de la surface à traiter (24) en direction de son bord.

7. Procédé selon l'une quelconque des revendications précédentes, caractérisé en ce que la surface à traiter (24) est mise en rotation.

8. Procédé selon l'une quelconque des revendications précédentes, caractérisé en ce que la vapeur (16) et/ou l'eau (18) sont envoyés sur la surface (24) selon une direction orthogonale à la surface (24) ou obliquement en direction de son bord.

9. Procédé selon l'une quelconque des revendications précédentes, caractérisé en ce que, après le processus de nettoyage, la surface (24) est séchée par de l'air chaud et/ou de la vapeur surchauffée (24) ou au moyen d'une essoreuse centrifuge gyroscopique

10. Procédé selon l'une quelconque des revendications précédentes, caractérisé en ce que le nettoyage des surfaces contaminées (24) est effectué dans une station de nettoyage, en particulier dans une station travaillant en continu.

11. Procédé selon l'une des revendications précédentes, caractérisé en ce que la vapeur (16) est pulvérisée sur la surface (24) à une pression allant jusqu'à 10 bars.

12. Procédé selon l'une quelconque des revendications précédentes, caractérisé en ce qu'il est mis en oeuvre dans le cas de processus de polissage chimico-mécanique, de la fabrication de masques, de la production d'éléments à cristaux liquides, de la fabrication de disques durs, de la micromécanique, des têtes de lecture pour disques durs, etc.

13. Dispositif pour la mise en oeuvre d'un procédé selon l'une quelconque des revendications précédentes, comportant au moins une buse de vapeur (1) dirigée vers la surface à traiter (24) ainsi qu'une buse de pulvérisation (46) séparée de la buse de vapeur (1) et destinée à produire une pellicule d'eau (47) sur la surface à traiter (24), dans lequel la buse de pulvérisation (46) et la buse de vapeur (1) sont dirigées vers la surface à traiter (24).

14. Dispositif selon la revendication 13, caractérisé en ce que l'on prévoit un dispositif de transport (30) pour les objets comportant les surfaces à nettoyer (24), en particulier des objets plats (21) en forme de rondelles.

15. Dispositif selon la revendication 14, caractérisé en ce que le dispositif de transport (30) transporte les objets (21) sans contact.

16. Dispositif selon la revendication 14 ou 15, caractérisé en ce que le dispositif de transport (30) fait tourner les objets (31) et/ou les transporte à travers une station de nettoyage.

17. Dispositif selon l'une quelconque des revendications 14 à 15, caractérisé en ce que le dispositif de transport (30) comporte, sur sa face supérieure, des buses de vapeur et/ou de liquide (33, 37) qui servent à produire un coussin de transport (34) pour l'objet (21).

18. Dispositif selon la revendication 17, caractérisé en ce que la direction de sortie des buses (33, 37) est suivant la direction de transport ou la direction de rotation.

19. Dispositif selon l'une quelconque des revendications 14 à 18, caractérisé en ce que le dispositif de transport (30) comporte un dispositif (42) servant en particulier pour l'amenée d'eau avec lequel on évacue les souillures (49) qui ont été détachées.

20. Dispositif selon l'une quelconque des revendications 14 à 19, caractérisé en ce que le dispositif de transport (30) est muni de buses de nettoyage (37) conduisant la vapeur (16).

21. Dispositif selon l'une quelconque des revendications 14 à 20, caractérisé en ce que le dispositif de transport (30) comporte des éléments de maintien (39), en particulier escamotables, tels que des tiges , des galets ou analogues, qui s'accrochent latéralement sur l'objet (21).

22. Dispositif selon l'une quelconque des revendications 13 à 21, caractérisé en ce que la buse de pulvérisation (46) et/ou la buse de vapeur (1) est une buse à large fente.

23. Dispositif selon l'une quelconque des revendications 13 à 22, caractérisé en ce que la buse de pulvérisation (26) et la buse de vapeur (1) sont installées essentiellement dans même position sur la surface à nettoyer (24).

24. Dispositif selon l'une quelconque des revendications 13 à 23, caractérisé en ce que la buse de pulvérisation (26) et/ou la buse de vapeur (1) peuvent être pivotées et/ou déplacées.
